(19) Europäisches Patentamt
European Patent Office
Office européen des brevets

(11) **EP 2 703 828 B1**

(12) **EUROPÄISCHE PATENTSCHRIFT**

(45) Veröffentlichungstag und Bekanntmachung des Hinweises auf die Patenterteilung:
**04.11.2020 Patentblatt 2020/45**

(51) Int Cl.:
***G01R 31/08*** *(2020.01)*

(21) Anmeldenummer: **13003894.6**

(22) Anmeldetag: **05.08.2013**

(54) **Vorrichtung zur Reduzierung von Störeinflüssen bei der Mantelfehlerortung**

Device for reducing interference in the localisation of jacket defects

Dispositif de réduction d'influences perturbatrices lors de la localisation de défauts de gaine

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.09.2012 DE 102012017869**

(43) Veröffentlichungstag der Anmeldung:
**05.03.2014 Patentblatt 2014/10**

(73) Patentinhaber: **Hagenuk KMT Kabelmesstechnik GmbH**
**01471 Radeburg (DE)**

(72) Erfinder:
• **Stephan, Marco**
**01561 Tauscha (DE)**
• **Küttner, Marco**
**01159 Dresden (DE)**
• **Purschwitz, Rainer**
**01187 Dresden (DE)**

(74) Vertreter: **Marschall, Stefan et al**
**Elbpatent**
**Marschall & Partner PartGmbB**
**Jessenstrasse 4**
**22767 Hamburg (DE)**

(56) Entgegenhaltungen:
EP-A1- 0 010 841    DE-T2- 60 029 233
US-A- 3 727 128     US-A- 3 991 363
US-A- 4 039 938     US-A- 4 896 117
US-A1- 2002 071 508

## Beschreibung

Die Erfindung betrifft eine Vorrichtung zur Reduzierung von einem Nutzsignal additiv überlagerten Störsignalen bei der Mantelfehlerortung an erdverlegten Leitungen, wobei die Vorrichtung einen Signaleingang, einen Signalausgang und eine Korrektureinheit aufweist, wobei am Signaleingang das Eingangssignal anliegt, welches eine additive Überlagerung eines Sendesignals (s(t)) mit einem Störsignal, insbesondere einem transienten Störsignal oder einer überlagerten Gleichspannung, ist und das Sendesignal ein gepulstes Gleichspannungssignal ist, wobei eine Störsignalzeitkonstante größer ist als eine Sendesignalperiode

Bei erdverlegten Kabeln werden Mantelfehler mittels Mantelfehlerortung geortet um eine genaue Lokalisierung der Position der Fehlerstelle durchzuführen und somit einen möglichst kleinen Bereich des Kabels ausgraben zu müssen.

Bei dieser Fehlerortung wird eine gepulste Gleichspannung durch einen Sender zwischen Kabelschirm und Erdpotential angelegt. An der Fehlerstelle fließt Strom vom Kabelschirm durch den Kabelmantel ins Erdreich, und somit zurück zum Erdpotential des Senders.

Bedingt durch den elektrischen Widerstand des Erdbodens und den fließenden Strom bildet sich an der Fehlerstelle des Mantels ein Spannungstrichter, anhand dessen mittels eines Messgerätes an der Erdoberfläche durch galvanische Kopplung mittels Erdspießen eine Spannung gemessen werden kann.

Nähert man sich über der Leitung der Fehlerstelle, steigt die an der Oberfläche messbare Spannung zur Fehlerquelle hin an, ist direkt über der Fehlerstelle gleich Null und ändert nach der Fehlerstelle ihre Polarität.

Dabei besteht häufig das Problem, dass additiv überlagerte Spannungen die Messung beeinträchtigen. Besonders störend sind dabei exponentiell abfallende transiente Störungen, welche beispielsweise durch das Einstechen der Erdspieße in die Erde verursacht werden. Diese Transiente kann um ein vielfaches größer sein als die zu messende gepulste Gleichspannung. Dabei ist die Zeitkonstante für gewöhnlich deutlich größer als die Periode der gepulsten Gleichspannung. Somit sind Messungen während der Abklingzeit nicht valide.

Diesem Problem wird nach dem Stand der Technik mit zwei Methoden beigekommen.

Zum einen wird eine Hochpassfilterung eingesetzt. Im einfachsten Fall wird ein RC-Hochpass verwendet. Dessen Zeitkonstante ist für gewöhnlich deutlich kleiner als die Periode der gepulsten Gleichspannung. Daraus folgt, dass der RC-Hochpass als Differenzierer wirkt. Bei einem Rechtecksignal führt das dazu, dass dies ein Umschwingen zu den Zeiten der Flanken des Rechtecksignals führt. Dieses Umschwingen erschwert oder verhindert sogar, dass eine Polarität erkannt wird. Dies hat wiederum zur Folge, dass eine Aussage in Bezug auf die Fehlerrichtung nicht möglich oder erschwert ist.

Zum anderen kann ein Benutzer selbständig die Offsetspannung herausregeln. In diesem Falls kann die Polarität - und somit die Richtung des Mantelfehlers - erkannt werden. Bei diesem "Herausregeln" ist große Erfahrung gefordert, da dies nicht so einfach ist. Zudem erschweren insbesondere Stecktransienten diese Art der Regelung, da der Benutzer entweder ständig nachregeln muss oder er abwartet bis die Stecktransiente abgeklungen ist. Dieses Abklingen kann dabei mehrere Minuten dauern. Insbesondere vor dem Hintergrund, dass viele Messungen bis zur endgültigen Lokalisation des Mantelfehlers durchgeführt werden müssen, kann dieses zu einer sehr zeitintensiven Messung führen. US 4 039 938 A offenbart die Ortung eines elektrischen Leckpfadfehlers in der Isolierung eines vergrabenen Leiters, indem zwischen Leiter und Erde ein gepulstes Signal angelegt wird, das dann an Stellen entlang des Leiterpfades erfasst wird. Das abgetastete Signal wird gleichgerichtet und durch zwei geteilt, um ein Referenzsignal zu erzeugen, dessen Phase mit dem abgetasteten Signal verglichen wird, um den Leiter bis zum Fehler zu verfolgen.

Die Aufgabe der Erfindung ist es den Stand der Technik zu verbessern.

Gelöst wird die Aufgabe durch eine Vorrichtung zur Reduzierung von einem Nutzsignal additiv überlagerten Störsignalen bei der Mantelfehlerortung an erdverlegten Leitungen gemäss dem Anspruch 1.

Somit können die Störsignale messtechnisch "herausgefiltert" werden. Dies wiederum führt zu einer wesentlich schnelleren Ortung des Mantelfehlers, was wiederum zu einem schnelleren Beheben des Mantelfehlers führt.

Ein "Eingangssignal" entspricht insbesondere dem mit Erdspießen gemessenen Signal für den Spannungsverlauf. Insbesondere ist das Eingangssignal ein Sendesignal, welches von einem Störsignal (additiv) überlagert ist.

Ein "Nutzsignal" ist das Signal, anhand dessen ein Benutzer oder entsprechend eine Messvorrichtung eine Aussage über Richtung eines Mantelfehlers trifft. Im Idealfall entspricht das Nutzsignal dem Sendesignal, wobei im Realfall durchaus Signalverzerrungen vorliegen können.

An einem "Signaleingang" liegt das Eingangssignal an. Dieser Signaleingang kann eine Sample-and-Hold-Schaltung aufweisen oder eine Signalkonditionierung durchführen.

An einem "Signalausgang" liegt insbesondere das Nutzsignal an, welches insbesondere um das Störsignal "bereinigt" ist.

Sowohl Signaleingang als auch Signalausgang können Softwarerepräsentationen umfassen. So kann an einem Hardwarespeicher oder einer Hardwareadresse der Wert an einem (virtuellen) Signaleingang oder Signalausgang gespeichert oder abgelegt sein.

Eine "Korrektureinheit" umfasst eine elektrische Schaltung, welche automatisch das am Signaleingang anliegende Eingangssignal um das Störsignal "bereinigt". Insbesondere kann die Korrektureinheit eine FPGA-Schaltung oder eine Mikrocontroller-Schaltung aufweisen, welche jeweils mit entsprechend eingerichteter Software- oder Hardware-Realisierung eines Korrekturalgorithmus ausgestattet sind.

Ein "Sendesignal" ist insbesondere eine Wechselspannung, welche zwischen einem Kabelschirm und einem Erdpotential angelegt wird. Bevorzugt handelt es sich um eine negativ gepulste Gleichspannung mit einem rechteckförmigen Signalverlauf.

Als "Störsignal" werden Signale gewertet, welche additiv das Sendesignal überlagern. : Transiente Signale sind umfasst, wie sie insbesondere beim Einstecken von Erdspießen ins Erdreich entstehen. Weiterhin sind Störsignale mit langen Störsignalzeitkonstante, auch Abklingzeitkonstanten genannt, umfasst, wobei lang in diesem Sinne bedeutet, dass innerhalb einer Periodendauer des Sendesignals (Sendesignalperiode) das Störsignal noch nicht messtechnisch vollständig abgeklungen ist.

Ein "Korrektursignal" ist insbesondere ein mittels Korrektureinheit Signal, welches von dem Eingangssignal "subtrahiert" wird, sodass idealer Weise das additive Störsignal eliminiert ist. Im idealen Fall entspricht das Korrektursignal dem Störsignal. Unter subtrahieren im vorliegenden Falle fällt auch ein Herausfiltern des Störsignals, sodass das eigentliche Sendesignal verbleibt.

Die Korrektureinheit kann zudem das Nutzsignal "erzeugen". Damit umfasst sind die Fälle, in denen algorithmisch und messtechnisch das Sendesignal bestimmt wurde und beispielsweise über eine einstellbare Spannungsquelle am Signalausgang bereitgestellt wird. Auch eine Softwarerepräsentanz des Wertes des Nutzsignals ist umfasst. So kann dieser Software-Wert beispielsweise mittels Software und zugehöriger Hardware weiterverarbeitet werden.

Um eine möglichst einfache und kostengünstige schaltungstechnische Möglichkeit für das Eliminieren des Störsignals bereitzustellen, kann die Korrektureinheit einen Tiefpass, insbesondere ein gleitenden Mittelwertfilter, ein FIR-Filter und/oder ein IIR-Filter, aufweisen, welcher frequente Anteile des Nutzsignals ermittelt oder eliminiert.

Die Korrektureinheit weist eine Verzögerungseinrichtung auf, welche das Eingangssignal zeitlich verzögert, sodass eine zeitliche Verzögerung der Filter kompensiert wird.

Weiterhin weist die Korrektureinheit einen Gleichspannungsanteilschätzer auf, insbesondere ein Medianfilter, und den geschätzten Gleichspannungsanteil dem Eingangssignal zur Eliminierung aufprägen.

In einem weiteren Aspekt der Erfindung wird die Aufgabe gelöst durch eine Mantelfehlerortungsvorrichtung, welche eine Sendesignaleinrichtung, eine Messeinrichtung und eine Vorrichtung nach einem der vorherigen Ansprüche aufweist.

Es kann somit eine Vorrichtung zur Mantelfehlerortung bereitgestellt werden, welche direkt eine obige Korrektureinrichtung aufweist, sodass direkt und automatisch beim Lokalisieren eines Mantelfehlers Korrekturen an den Messsignalen erfolgen.

"Sendesignaleinrichtung" und "Messeinrichtung" entsprechen den bekannten Vorrichtungen zum Bestimmen eines Mantelfehlers, bei dem an einer Fehlerstelle des Kabels an der Erdoberfläche Potentialdifferenzen gemessen werden.

In einer Ausführungsform umfasst die Messeinrichtung wenigstens zwei Erdspieße. Somit kann ein Vektor in Richtung Fehlerquelle bestimmt werden.

Um ein besonders effektives automatisches Korrigieren zu ermöglichen, wird ein Wert einer Sendesignalperiode der Sendesignaleinrichtung an die Korrektureinheit übermittelt oder in der Korrektureinheit ermittelt.

Im Weiteren wird die Erfindung anhand von Ausführungsbeispielen näher erläutert. Es zeigen

Figur 1    eine schematische Darstellung eines Spannungsverlaufs einer negativen gepulsten Gleichspannung, wie sie zwischen einem Kabelmantel und dem Erdpotential angelegt wird,

Figur 2    eine schematische Darstellung eines Spannungsverlaufs einer transienten Störung, aufgrund von Einstechen von Erdspießen,

Figur 3    eine schematische Darstellung eines Spannungsverlaufs beim Verwenden eines Hochpassfilters nach dem Stand der Technik,

Figur 4    eine schematische Darstellung einer erfindungsgemäßen Korrekturvorrichtung,

Figur 5    eine schematische Darstellung eines Amplitudenspektrums des Nutzsignals,

Figur 6    eine schematische Darstellung des Eingangssignals (oben) und eines Ausgangssignals, wobei das Ausgangssignal eine zeitliche Verzögerung und einen additiven Gleichspannungsanteil aufweist,

Figur 7    eine schematische Darstellung einer Wahrscheinlichkeitsdichtefunktion eines kompensierten Nutzsignals mit negativer Polarität,

Figur 8 eine schematische Darstellung des Lokalisieren eines Mantelfehlers eines erdverlegten Kabels mittels Erdspießen und

Figur 9 eine schematische Darstellung eines Potentialverlauf im Erdboden bei einer Messung an der Erdoberfläche.

Beim Lokalisieren eines Mantelfehlers 859 eines erdverlegten Mittelspannungskabels 857 wird eine gepulste Gleichspannung mit einer Rechteckform mittels eines Gleichspannungsgenerators 861 zwischen einem Kabelmantel des Kabels 857 und dem Erdreich (Erdpotential) angelegt.

An der Fehlerstelle 859 fließt ein Strom vom Kabelschirm durch den Kabelmantel ins Erdreich und somit zurück zum Erdpotential des Senders 861. Bedingt durch den elektrischen Widerstand des Erdbodens und den fließenden Strom bildet sich an der Fehlerstelle ein Spannungstrichter aus welcher mittels Potentialmessgerät an der Erdoberfläche durch galvanische Kopplung mittels Erdspießen 855 detektiert wird.

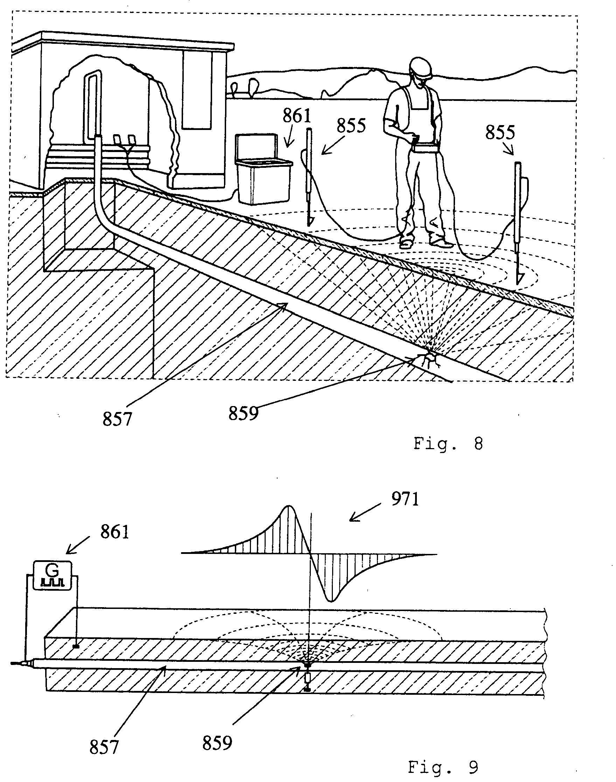

Die an der Oberfläche messbare Schrittspannung 971 steigt zur Fehlerstelle 859 hin an und ändert nach der Fehlerstelle 859 ihre Polarität (siehe Fig. 9).

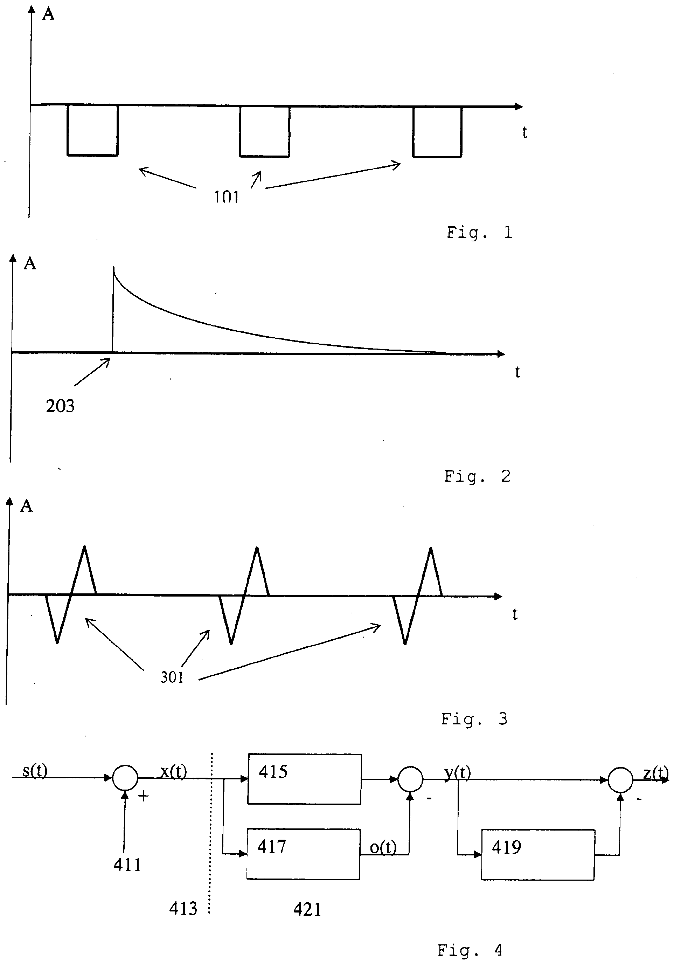

Beim Einstechen der Erdspieße 855 ins Erdreich entstehen teilweise transiente Störungen 411 mit einem Spannungsverlauf wie er in Fig. 2 dargestellt ist. Diese Störspannungen 411 bewirken eine additive Überlagerung zum Sendesignal s(t), sodass sich ein Eingangssignal x(t) ergibt (siehe Fig. 4).

Nach dem Stand der Technik wurde zum Eliminieren derartiger Störungen 411 bisher ein Hochpassfilter verwendet. Das dabei entstandene Signal ist in Fig. 3 dargestellt, wobei die Zeitkonstante des Hochpasses kleiner als die Impulszeit ist.

Nachteilig bei dieser Hochpassvariante ist, dass das Ausgangssignal ein Umschwingen verursacht. Dieses erschwert deutlich das Erkennen der Polarität der Eingangsspannung, sodass eine Aussage über die Fehlerrichtung nicht oder nur schwer zu erhalten ist.

Vorliegend wird eine Lösung präsentiert, welche automatisch aus dem Eingangssignal x(t) eines Empfängers eine Offsetspannung o(t) generiert. Das Eingangssignal x(t) sei vorliegend eine Überlagerung der gepulsten Rechteckspannung s(t) (siehe Fig. 4 und Fig. 1, Bezugszeichen 101) und einem Stecktransientensignal 411 (siehe Fig. 4 und Fig. 2), welches beim Einstecken eines Erdspießes (855) zum Zeitpunkt 203 entsteht.

Bei den Figuren 1 und 2 sind die Amplituden A über die Zeit t dargestellt, wobei das Stecktransientensignal 411 eine Störsignalzeitkonstante aufweist, welche größer ist als eine Sendesignalperiode T des getakteten Gleichspannungssignals s(t).

Ein durch die Lösung gelöstes Problem bei der Automatisierung ist, dass ein Nutzsignal ein Generieren der Offsetspannung (negativ) beeinflusst. Demzufolge wird ein Filter vorgeschlagen, welches in der Lage ist, das Nutzsignal effektiv zu eliminieren, jedoch ein Offsetstörsignal möglichst unbeeinflusst belässt.

Die Lösung ist in einer ersten Alternativen ein Tiefpassfilter 417, welches das Nutzsignal auslöscht. Eine Fourierreihenzerlegung eines Rechtecksignals mit beliebigem Tastverhältnis zeigt, dass das Nutzsignal aus einem Gleichanteil $A_{DC}$ besteht, sowie aus den Frequenzen $f_g=1/T_p$.

Somit gilt

$$s(t) = A_{DC} + \sum_{k=1}^{\infty} A_{+k} \cdot e^{j \cdot 2 \cdot \pi \cdot k \cdot f_g} + A_{-k} \cdot e^{-j \cdot 2 \cdot \pi \cdot k \cdot f_g}$$

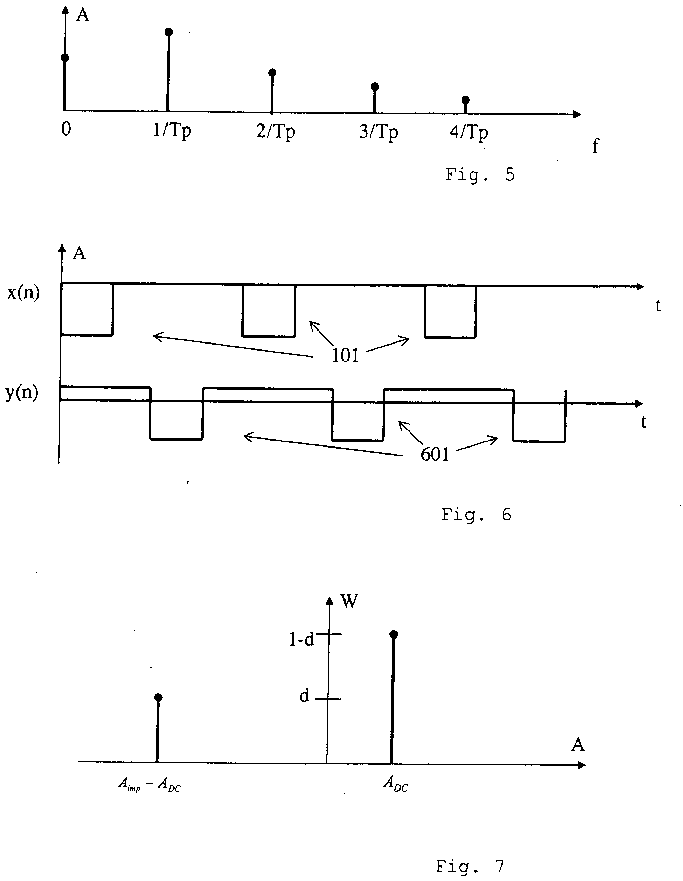

Das Spektrum (siehe Fig. 5) des Nutzsignales ist diskret und besteht aus einem Gleichanteil $A_{DC}$, einer Grundfrequenz $f_g$, welche der Inversen der Signalperiode $T_p$ entspricht, sowie vielfachen der Grundfrequenz.

Wird der Gleichanteil außen vor gelassen, liegt die Lösung in einem Moving-Average-Filter 417 (Tiefpassfilter) der Ordnung N unter bestimmten Voraussetzungen diese Eigenschaft. Seine Transferfunktion lautet

$$H_{MA}(z) = \frac{1}{N+1} \sum_{n=0}^{N} z^{-n}$$

Und damit besteht der Frequenzgang

$$H_{MA}(\Omega) = \frac{\sin((N+1)\cdot\Omega)}{(N+1)\cdot\Omega}\cdot e^{-j\Omega N/2} \quad mit \quad \Omega = \pi\frac{f}{f_a}$$

in Abhängigkeit der normierten Kreisfrequenz Ω, welche das Verhältnis aus der Frequenz f zur Abtastfrequenz $f_a$ bestimmt wird. Der Frequenzgang zeigt, dass der Amplitudengang des Filters eine sinc-Funktion beschreibt, sowie eine Verzögerung von N/2 Samples erzeugt.

Die Nullstellen im Frequenzgang des Filters liegen bei Vielfachen von

$$(N+1)\cdot\pi\cdot\frac{f}{f_a} = i\cdot\pi \quad mit \quad i = 1;2;3;\dots$$

Da die Signalfrequenzen ausgelöscht werden sollen muss der Filter Nullstellen bei den Frequenzen

$$f_{Null} = \frac{k}{T_p}\cdot \quad mit \quad k = 1;2;3;\dots$$

aufweisen. Demzufolge gilt für die Filterordnung

$$N = \frac{i}{k}f_a\cdot T_p - 1 \quad mit \quad i = 1;2;3;\dots \quad und \quad k = 1;2;3;\dots$$

Da die Filterordnung N eine natürliche Zahl sein soll, ist die Abtastfrequenz $f_a$ ein ganzes Vielfaches der Grundfrequenz $f_g$ des Signales, damit die Nullstellen genau bei den Frequenzen des Nutzsignales liegen. Ist nur das Nutzsignal am Eingang des Empfängers vorhanden gilt:

$$o(n) = h_{MA}(n) * x(n) = h_{MA}(n) * s(n) = A_{DC} \quad für \quad N = \frac{i}{k}f_a\cdot T_p - 1$$

Übrig bleibt nur ein konstanter Term, welcher dem DC-Anteil des Nutzsignales entspricht. Um eine möglichst kurze Einschwingzeit des Filters zu gewährleisten, wird die Filterordnung möglichst klein gewählt. Die Kleinste Filterordnung ergibt sich bei i=1 und k=1. Demzufolge ist die minimal mögliche Filterordnung:

$$N_{Min} = f_a\cdot T_p - 1$$

Dieses Filter weist demzufolge eine Verzögerung von $\frac{N_{Min}}{2} = \frac{f_a\cdot T_p - 1}{2}$ Samples auf. Diese Verzögerung des Filters muss durch eine Verzögerungseinrichtung korrigiert werden. Die Verzögerungseinrichtung 415 ist in Fig. 4 schematisch dargestellt.

In Fig. 6 ist das Verhalten der Kompensationsschaltung (415, 417) dargestellt. Das Ausgangssignal y(n) entspricht dem zeitverschobenen Eingangssignal x(n) bis auf den fehlenden Gleichanteil $A_{DC}$ des Nutzsignales. Die Impulshöhe $A_{imp}$ des Eingangssignales wird beim Auftreten des Impulses verringert um den Gleichanteil $A_{DC}$. Währenddessen in den . Impulspausen ein neuer Offsetanteil entsteht mit der Höhe $A_{DC}$.

Im Folgenden wird die Schätzung des Gleichanteiles erläutert:

Da es störend ist, dass das Ausgangssignal gleichanteilsfrei ist, wird vorliegend eine zusätzliche Lösung für die Schätzung des Gleichanteils $A_{DC}$ dargestellt.

Die Wahrscheinlichkeitsdichtefunktion eines gleichanteilslosen Nutzsignales mit einem Tastgrad d und negativer Polarität ist in Fig. 7 schematisch dargestellt.

Dieses Nutzsignal weist zwei diskrete Werte auf. Bei der Amplitude $A_{DC}$ treten die Werte des Nutzsignales mit der Wahrscheinlichkeit von 1-d auf. Die um den Gleichanteil verringerte Amplitude tritt mit der Wahrscheinlichkeit d auf.

Für eine positive Polarität würde sich die Wahrscheinlichkeitsdichtefunktion spiegelsymmetrisch zur Achse der Wahrscheinlichkeit verhalten.

Es wird vorausgesetzt, dass der Tastgrad wesentlich keiner als 0,5 ist (d « 0,5). Somit lässt sich ein einfacher Schätzer für den Gleichanteil $A_{DC}$ konstruieren.

Es wird ein Sample gewählt, welches den $A_{DC}$-Anteil repräsentiert. Es wird ein Sample benutzt, welches mit der Wahrscheinlichkeit 1-d auftritt. Eine der Amplitude nach sortierte Liste von Samples zeigt, dass für d « 0,5 das mittlere Sample stets den Gleichanteil repräsentiert und zwar unabhängig von der Polarität des Nutzsignales.

Somit ist ein Medianfilter ein geeigneter Schätzer für den Gleichanteil des gleichanteilslosen Nutzsignales. Der Medianfilter weist eine Ordnung vom Vielfachen von $N_{Min}$ auf, um die Wahrscheinlichkeitsdichtefunktion optimal zu repräsentieren. Um eine möglichst kurze transiente Einschwingzeit des Medianfilters zu gewährleisten, besitzt dieser die Ordnung $N_{Min}$.

Zusammenfassend wird ausgeführt, dass ein gestörtes Eingangssignal x(t) mittels des Filters 417 gefiltert und durch den Zeitverzögerer 415 zeitverzögert wird, sodass ein Zwischennutzungssignal y(t) vorliegt.

Anschließend erfolgt noch zusätzlich mittels des Gleichanteilsschätzers 419 eine Gleichanteilsschätzung, sodass das Signal z(t) am Signalausgang anliegt und im Wesentlichen dem Sendesignal s(t) entspricht.

Das Filter 417 und der Zeitverzögerer 415 bilden zusammen eine Korrektureinheit.. Diese Korrektureinheit umfasst zusätzlich den Gleichanteilsschätzers 419.

## Patentansprüche

1. Vorrichtung zur Reduzierung von einem Nutzsignal additiv überlagerten Störsignalen bei der Mantelfehlerortung an erdverlegten Leitungen, wobei die Vorrichtung einen Signaleingang (413), einen Signalausgang und eine Korrektureinheit (415, 417, 419) mit einem Filter (417), einer Verzögerungseinrichtung (415) und einem Gleichspannungsanteilschätzer (419) aufweist,

   wobei am Signaleingang (413) das Eingangssignal (x(t)) anliegt, welches eine additive Überlagerung eines Sendesignals (s(t)) mit einem Störsignal (411) ist, wobei das Sendesignal (s(t)) ein gepulstes Gleichspannungssignal (101) ist, und wobei das Störsignal ein transientes Störsignal oder eine überlagerte Gleichspannung ist,

   wobei eine Störsignalzeitkonstante größer ist als eine Sendesignalperiode und wobei die Korrektureinheit automatisch ein Korrektursignal ermittelt und dieses dem Eingangssignal aufprägt, sodass an dem Signalausgang das Nutzsignal anliegt,

   wobei die Korrektureinheit dazu eingerichtet ist

   - das Eingangssignal (x(t)) mittels des Filters (417) zu filtern und mittels der Verzögerungseinrichtung (415) eine Filterverzögerung zu kompensieren, so dass ein Zwischennutzungssignal (y(t)) vorliegt, sowie
   - mittels des Gleichspannungsanteilschätzers einen Gleichanteil ($A_{DC}$) des Nutzsignals zu schätzen und dem Zwischennutzungssignal (y(t)) aufzuprägen.

2. Vorrichtung nach Anspruch 1, **dadurch gekennzeichnet, dass** die Korrektureinheit das Störsignal ermittelt oder eliminiert, wobei das Nutzsignal im Wesentlichen unbeeinflusst ist.

3. Vorrichtung nach einem der vorherigen Ansprüche, **dadurch gekennzeichnet, dass** die Korrektureinheit einen Tiefpass (417), insbesondere ein gleitenden Mittelwertfilter, ein FIR-Filter und/oder ein IIR-Filter, aufweist, welcher frequente Anteile des Nutzsignals ermittelt oder eliminiert.

4. Vorrichtung nach einem der vorherigen Ansprüche, **dadurch gekennzeichnet, dass** der Gleichspannungsanteilschätzer (419), ein Medianfilter ist.

5. Mantelfehlerortungsvorrichtung, welche eine Sendesignaleinrichtung (861), eine Messeinrichtung und eine Vorrichtung nach einem der vorherigen Ansprüche aufweist.

## Claims

1. A device for reducing interference signals additively superposed on a useful signal during sheath fault location on buried lines, wherein the device has a signal input (413), a signal output and a correction unit (415, 417, 419) with a filter (417), a delay device (415) and a DC component estimator (419),

   wherein the input signal (x(t)) is applied at the signal input (413), which is an additive superposition of a transmit signal (s(t)) with an interference signal (411), wherein the transmit signal (s(t)) is a pulsed DC voltage signal (101), and wherein the interference signal is a transient interference signal or a superposed DC voltage, wherein an interference time constant is greater than a transmit signal period, and wherein the correction unit automatically determines a correction signal and impresses the latter on the input signal, so that the useful signal is applied at the signal output, wherein the correction unit is set up to

- filter the input signal (x(t)) by means of the filter (417), and compensate a filter delay by means of the delay device (415), so that an intermediate useful signal (y(t)) is present, as well as to
- estimate a steady component ($A_{DC}$) of the useful signal by means of the DC voltage component estimator and impress it on the intermediate useful signal (y(t)).

2. The device according to claim 1, **characterized in that** the correction unit determines or eliminates the interference signal, wherein the useful signal is essentially uninfluenced.

3. The device according to one of the preceding claims, **characterized in that** the correction unit has a lowpass filter (417), in particular a sliding mean value filter, a FIR filter and/or an IIR filter, which determines or eliminates frequent components of the useful signal.

4. The device according to one of the preceding claims, **characterized in that** DC voltage component estimator (419) is a median filter.

5. A sheath fault location device, which has a transmit signal device (861), a measuring device and a device according to one of the preceding claims.

## Revendications

1. Dispositif de réduction de signaux de perturbation recouverts additionnellement par un signal utile lors de la localisation de défauts de gaine au niveau de câbles posés dans la terre, le dispositif présentant une entrée de signal (413), une sortie de signal et une unité de correction (415,417,419) comportant un filtre (417), un dispositif de retardement (415) et un évaluateur de part de tension continue (419), étant appliqué à l'entrée de signal (413) le signal d'entrée (x(t)) qui est une superposition additionnelle d'un signal d'émission (s(t)) avec un signal de perturbation (411), le signal d'émission (s(t)) étant un signal pulsé de tension continue (101), et le signal de perturbation étant un signal de perturbation transitoire ou une tension continue superposée, une constante temporelle de signal de perturbation étant supérieure à une période de signal d'émission et l'unité de correction déterminant automatiquement un signal de correction et impartissant celui-ci au signal d'entrée, de sorte que le signal utile est appliqué à la sortie de signal, l'unité de correction étant conçue pour

- filtrer le signal d'entrée (x(t)) au moyen du filtre (417) et compenser un retardement de filtre au moyen du dispositif de retardement (415), de sorte qu'un signal d'utilisation intermédiaire (y(t)) est présent, et
- au moyen de l'évaluateur de part de tension continue, estimer une part constante ($A_{DC}$) du signal utile et l'impartir au signal d'utilisation intermédiaire (y(t))

2. Dispositif selon la revendication 1, **caractérisé en ce que** l'unité de correction détermine ou élimine le signal de perturbation, le signal utile étant sensiblement inchangé.

3. Dispositif selon une des revendications précédentes, **caractérisé en ce que** l'unité de correction présente un passe-bas (417), en particulier un filtre glissant de valeur moyenne, un filtre FIR et/ou un filtre IIR qui détermine ou élimine des parts fréquentes du signal utile.

4. Dispositif selon une des revendications précédentes, **caractérisé en ce que** l'évaluateur de parts de tension continue (419) est un filtre médian.

5. Dispositif de localisation de défauts de gaine, qui présente un dispositif à signal d'émission (861), un dispositif de mesure et un dispositif selon une des revendications précédentes.

Fig. 1

Fig. 2

Fig. 3

Fig. 4

Fig. 5

Fig. 6

Fig. 7

861  855  855

857  859

Fig. 8

971

861

G

857  859

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4039938 A